Europäisches Patentamt

European Patent Office

Office européen des brevets

(11) Publication number: **0 417 946 A2**

# EUROPEAN PATENT APPLICATION

(21) Application number: **90309574.3**

(22) Date of filing: **31.08.90**

(51) Int. Cl.5: **C08J 7/04**, C08J 5/18, C09D 163/00

(30) Priority: **14.09.89 GB 8920799**

(43) Date of publication of application:
**20.03.91 Bulletin 91/12**

(84) Designated Contracting States:
**BE CH DE FR GB IT LI NL**

(71) Applicant: **IMPERIAL CHEMICAL INDUSTRIES PLC**
**Imperial Chemical House, Millbank**
**London SW1P 3JF(GB)**

(72) Inventor: **Adkins, Kelvin Patrick**
**Almesteda, Colchester Road**
**Elmstead Market, Essex(GB)**

(74) Representative: **Rhind, John Lessels et al**
**Imperial Chemical Industries PLC Legal**
**Department: Patents PO Box No 6 Bessemer**
**Road**
**Welwyn Garden City Herts AL7 1HD(GB)**

(54) **Polymeric film.**

(57) A flame-retardant film comprises a polymeric substrate having a receptive layer to which is bonded a retardant layer comprising a flame-retardant agent consisting essentially of a halogenated epoxy resin.

A modifying layer, such as a slip coat or an adhesive barrier layer, is preferably applied to the retardant layer.

The film exhibits improved adhesion to inks and photo-curable varnishes and is of utility in the electrical field.

Fig.4.

## POLYMERIC FILM

This invention relates to a polymeric film and, in particular, to a flame-retardant polymeric film.

Plastics materials intended for use as component parts of devices and appliances are subjected to increasingly stringent safety requirements. In particular, polymeric components for incorporation into electrical equipment, including printed circuit boards, membrane touch switch assemblies and electrical insulation panels and liners, are required to exhibit flame-retardant characteristics.

Japanese Examined Patent Publication (Kokuku) JA-B-49.047915 discloses a flame-retardant film for electrical insulation which comprises a polyethylene terephthalate film of oxygen index not are than 32 coated with a costing agent chiefly comprising a brominated epoxy resin to which is added one, or more than one, curing agent comprising a polyamine or polyamide such that the weight of bromine in the brominated epoxy resin is in a range of from 1 to 10% in relation to the polyethylene terephthalate film.

Such films, although generally exhibiting acceptable flame-retardancy, have been observed to exhibit inferior adhesion to protective coatings and varnishes and, in particular, to the various photo-curable and conductive inks frequently employed in the production of electrical components.

We have now devised a flame-retardant film which overcomes or substantially eliminates the aforementioned problem.

Accordingly, the present invention provides a flame-retardant film comprising a polymeric substrate having a flame-retardant layer on a surface thereof wherein at least one surface of the substrate comprises a receptive layer and, on the at least one receptive layer, a retardant layer comprising a flame-retardant agent consisting essentially of a halogenated epoxy resin.

The invention also provides a method of producing a flame-retardant film comprising forming a polymeric substrate, treating at least one surface of the substrate to form a receptive layer thereon, and forming on the receptive layer a retardant layer comprising a flame-retardant agent consisting essentially of a halogenated epoxy resin.

Flammability of plastics materials is routinely assessed in accordance with a test programme specified by the Underwriters Laboratories Inc, and for the purposes of this invention a film is considered to be "flame-retardant" if it satisfies the criteria specified in the Underwriters Laboratories vertical burning text UL-94 VTM-2 of 1980.

A flame-retardant agent for use in accordance vith the invention is of the kind which operates to inhibit radical combustion reactions and to shroud the film surface thereby shielding it from oxygen in any region undergoing fusion and/or decomposition. Suitably, the flame-retardant agent comprises a halogenated epoxy resin, particularly a brominated epoxy resin. For effective behaviour the halogen content of the flame-retardant agent should be high - for example, at least 25%, preferably less than 55% and more preferably from 30 to 50% by weight of the flame-retardant agent. A particularly suitable resin comprises a polymeric glycidyl ether of brominated bisphenol A, such as that available under the trade name Quatrex 6410, supplied by the Dow Chemical Company, and containing of the order of 50 weight % of bromine. Such a resin has a relatively low softening point, ie about 80°C, and an epoxide equivalent weight of about 450.

As herein described and employed, the flame-retardant agent consists essentially of a halogenated epoxy resin, thereby denoting that the flame-retardant medium is essentially uncross-linked and/or devoid of an effective amount of a cross-linking or curing agent.

The flame-retardant agent is conveniently applied to the substrate in a coating medium comprising a solution or dispersion of the flame-retardant agent in a suitable volatile vehicle, particularly an organic solvent or dispersant medium. Suitable organic media include common solvents such as acetone, diacetone alcohol and methylethylketone.

Deposition of the flame-retardant solution or dispersion onto the polymeric substrate is effected by conventional film coating techniques - for example, by gravure roll coating, reverse roll coating, dip coating, bead coating, slot coating or electrostatic spray coating. The solution or dispersion is suitably applied in an amount such that the thickness of the applied layer when dried, for example - by heating the coated substrate, will provide effective flame-retardant behaviour. Conveniently, the thickness of the dried, flame-retardant layer is of the order of 2.5 μm, or less, for example from 0.1 to 2.5 μm, and preferably in a range of from 0.5 to 1.5 μm.

If desired, the behaviour of a film according to the invention may be improved by inclusion in the flame-retardant layer of an appropriate additive. For example, the handling characteristics of the film may be improved by inclusion in the flame-retardant layer of an anti-block agent, such as a polymeric wax. A particularly suitable wax comprises a polyolefin wax, such as a micronised modified polypropylene wax. Such a wax is also beneficial in reducing the susceptibility of the film assembly to stress-crazing. The required amount of wax is readily established by experimentation, but, in general, need not exceed about 1%, and is preferably from 0.25 to 0.75%, by weight of the flame-retardant agent.

Similarly, flexibility of the film assembly may be promoted by the inclusion in the flame-retardant layer of a compatible flex-promoting resin - for example, a high molecular weight (ie number average molecular weight Mn of at least 3,000, preferably at least 3,700) bisphenol A - epichlorohydrin epoxy resin in an amount conveniently not exceeding 100%, preferably from 30% to 50%, by weight of the flame-retardant agent.

Prior to deposition of the flame-retardant medium onto the polymeric substrate the exposed surface thereof is subjected to a surface-modifying treatment to provide a receptive layer thereon. The treatment may be chemical or physical, a convenient treatment, because of its simplicity and effectiveness, which is particularly suitable for the treatment of a polyolefin substrate, being to subject the exposed surface of the substrate to a high voltage electrical stress accompanied by corona discharge. Alternatively, the receptive layer may be created by pretreating the substrate with a medium known in the art to have a solvent or swelling action on the substrate polymer. Examples of such media, which are particularly suitable for the treatment of a polyester substrate, include a halogenated phenol dissolved in a common organic solvent, for example - a solution of p-chloro-m-cresol, 2,4-dichlorophenol, 2,4,5- or 2,4,6- trichlorophenol or 4-chlororesorcinol in acetone or methanol. In addition, and preferably, the treatment solution may contain a partially hydrolysed vinyl chloride-vinyl acetate copolymer. Such a copolymer conveniently contains from 60 to 98 per cent of vinyl chloride, and from 0.5 to 3% of hydroxyl units, by weight of the copolymer. The molecular weight (number average) of the copolymer is conveniently in a range of from 10,000 to 30,000 and preferably from 16,500 to 25,000.

A suitable receptive layer is formed by coating the polymeric substrate with a coating composition comprising a mixture of a styrene/butadiene copolymer and an acrylic or methacrylic polymer. fr preferred styrene/butadiene copolymer has a ratio of styrene:butadiene of approximately 1.4 mole :1.0 mole. A preferred acrylic or methacrylic polymer comprises methyl methacrylate/ethyl acrylate/methacrylamide, preferably in a ratio of 46/46/8 mole % respectively. The weight ratio of the styrene/butadiene copolymer to acrylic or methacrylic polymer can vary over a wide range, preferably from 1.0:0.1 to 10.0, more preferably from 1.0:0.25 to 4.0, and particularly 1.0:1.0.

If desired, a plurality of treatments may be sequentially applied to a substrate.

The treatment is suitably applied at a concentration or intensity which will yield a receptive layer having a dry thickness generally less than 1 $\mu$m, and preferably from 0.05 to 0.5 $\mu$m.

The substrate of a flame-retardant film according to the invention may be formed from any synthetic, film-forming polymeric material. Suitable thermoplastics materials include a homopolymer or copolymer of a 1-olefin, such as ethylene, propylene and but-1-ene, a polyamide, a polycarbonate, and, particularly, a synthetic linear polyester which may be obtained by condensing one or more dicarboxylic acids or their lower alkyl (up to 6 carbon atoms) diesters, eg terephthalic acid, isophthalic acid, phthalic acid, 2,5- 2,6- or 2,7- naphthalenedicarboxylic acid, succinic acid, sebacic acid, adipic acid, azelaic acid, 4,4'-diphenyldicarboxylic acid, hexahydroterephthalic acid or 1,2-bis-p-carboxyphenoxyethane (optionally with a monocarboxylic acid, such as pivalic acid) with one or more glycols, particularly aliphatic glycols, eg ethylene glycol, 1,3- propanediol, 1,4- butanediol, neopentyl glycol and 1,4-cyclohexanedimethanol. A polyethylene naphthalate, and particularly a polyethylene terephthalate film is preferred, especially such a film which has been biaxially oriented by sequential stretching in two mutually perpendicular directions, typically at a temperature in the range 70 to 125° C, and preferably heat set, typically at a temperature in the range 150 to 250° C, for example -as described in British Patent GB-A-838708.

The substrate may also comprise a polyarylether or thio analogue thereof, particularly a polyaryletherketone, polyarylethersulphone, polyaryletheretherketone, polyaryletherethersulphone, or a copolymer or thioanalogue thereof. Examples of these polymers are disclosed in EP-A-1879, EP-A-184458 and US-A-4008203, particularly suitable materials being those sold by ICI PLC under the Registered Trade Mark STABAR. Blends of these polymers may also be employed.

Suitable thermoset resin substrate materials include addition -polymerisation resins - such as acrylics, vinyls, bis-maleimides and unsaturated polyesters, formaldehyde condensate resins - such as condensates with urea, melamine or phenols, cyanate resins, isocyanate resins, epoxy resins, functionalised polyesters, polyamides or polyimides.

Although one, or more, of the aforementioned substrate materials, particularly the thermoset resins, may per se satisfy the criteria of UL-94 VTM-2, the provision thereon of a retardant layer as herein defined, may be beneficial in promoting adhesion of a subsequently applied coating without detriment to the flame-retardant performance of the substrate.

A polymeric film substrate for production of a flame-retardant film according to the invention may be unoriented, or uniaxially oriented, but is preferably biaxially oriented. A thermoplastics polymeric substrate is conveniently biaxially oriented by drawing in two mutually perpendicular directions in the plane of the film to achieve a satisfactory combination of mechanical and physical properties. Simultaneous biaxial orientation may be effected by extruding a thermoplastics polymeric tube which is subsequently quenched, reheated and then expanded by internal gas pressure to induce transverse orientation, and withdrawn at a rate which will induce longitudinal orientation. Sequential stretching may be effected in a stenter process by extruding the thermoplastics substrate material as a flat extrudate which is subsequently stretched first in one direction and then in the other mutually perpendicular direction. Generally, it is preferred to stretch firstly in the longitudinal direction, ie the forward direction through the film stretching machine, and then in the transverse direction. A stretched substrate film may be, and preferably is, dimensionally stabilised by heat-setting under dimensional restraint at a temperature above the glass transition temperature thereof.

The flame-retardant coating medium is suitably applied to a receptive surface of an already oriented, and preferably heat-set, film substrate.

The thickness of the substrate of a flame-retardant film according to the invention may vary over a wide range, but generally will be from 25 to 300, particularly from 50 to 175 and especially from 75 to 150 $\mu$m. The thicknesses of the respective layers deposited on the substrate are minor by comparison therewith. A film according to the invention may therefore be expected to exhibit a total thickness of from about 30 to 310 $\mu$m, especially 80 to 160 $\mu$m.

Although handling and other properties of a film according to the invention may, as hereinbefore described, be improved by incorporation into the flame-retardant layer(s) of an appropriate additive, such properties may, if desired, be improved by providing an additional layer (continuous or discontinuous) of material on the surface of the flame-retardant layer remote from the substrate. For example, a slip coat may be applied to the flame-retardant layer, to reduce the surface frictional characteristics thereof. Such a slip coat conveniently comprises a particulate additive, for example an organic or inorganic filler having an average particle size of from 25 to 250 nm, especially from 100 to 150 nm. Such fillers conveniently comprise a particulate oxide of a metal or metalloid, especially alumina and silica, and may be applied as a dispersion in a suitable volatile carrier vehicle at a concentration determined by the desired degree of improvement in surface characteristics.

If desired, the surface of the flame-retardant layer remote from the substrate may be modified by the provision of an adhesion-promoting barrier layer thereon. A modifying layer of this kind conveniently comprises a modifier resin exhibiting a relatively high softening point, greater than that of the flame-retardant agent, to seal the flame-retardant layer and minimise migration of the flame-retardant agent to the surface, thus reducing susceptibility to blocking at elevated temperatures. Desirably, the softening point of the modifying resin should be at least 100°C, preferably at least 200°C, for example -of the order of 250°C. A cellulosic resin, particularly a cellulose acetate resin, is a suitable modifier.

In an alternative embodiment of the invention, the modifying resin may be included in the flame retardant layer instead of, or in addition to, being present in an additional modifying layer.

Durability of a film according to the invention may be further improved by inclusion in a modifying layer of a high molecular weight (Mn $\geq$ 3,000, preferably $\geq$ 3,700) modifier resin compatible with the flame-retardant agent in the adjacent layer. A high molecular weight epoxy resin (Mn $\approx$ 3750) is suitable in this respect.

Particularly desirable barrier and adhesion characteristics are observed by provision of a modifying layer comprising a blend of two or more modifier resins - for example a high softening point resin and a high molecular weight flame-retardant-compatible resin. Thus, a blend of a cellulose acetate resin and an epoxy resin provides a particularly beneficial modifying surface layer. Two main effects are observed with such a blend:

a) increased compatibility of cellulose acetate with the underlying flame retardant layer, thus increasing inter coat-adhesion; and

b) discrete islands rich in cellulose acetate are formed on the coating surface which increase the coating durability and reduce surface friction giving the product good handling characteristics.

The modifying layer preferably comprises, as an additional component, an antiblocking agent, such as a polymeric wax, for example a micronised modified polypropylene wax.

The modifying barrier layer remains uncrosslinked during the coating process. Good adhesion with a wide range of inks and dielectrics is obtained by providing a surface with controlled susceptibility to attack by ink solvent systems, good compatibility with a range of ink carrier resins and potential susceptibility to photografting (to give good adhesion with cured dielectrics).

A modifying layer is conveniently deposited on a flame-retardant layer from a solution or dispersion of the modifier resin(s) in a suitable volatile vehicle, particularly an organic solvent or dispersant medium, such as methanol, diacetone alcohol and methylethylketone.

Deposition of a modifying layer is conveniently effected by a conventional film coating technique, as hereinbefore described, to leave a modifying layer which, after drying, has a thickness generally not exceeding 5.0 μm and preferably from 1.0 to 3.0 μm.

A flame-retardant layer may be applied to one or each surface of the polymeric substrate, and one or each flame-retardant layer subsequently may be provided with a super-imposed modifying layer. Alternatively, one surface of the substrate may be uncoated, or may be coated with a layer or layers other than the herein specified flame-retardant and modifying layers. In a preferred embodiment of the invention, a flame-retardant film comprises a seven layer structure: a substrate layer of a film-forming resin, such as a linear polyester, having on each surface thereof in sequence outwardly from the substrate a receptive layer, a flame-retardant layer and an adhesion-promoting barrier layer.

One or more of the polymeric layers of a film according to the invention may conveniently contain any of the additives conventionally employed in the manufacture of thermoplastics polymeric films. Thus, agents such as dyes, pigments, voiding agents. Lubricants, anti-oxidants, anti-blocking agents, surface active agents, slip aids, gloss-improvers, prodegradants, ultra-violet light stabilisers, viscosity modifiers and dispersion stabilisers may be incorporated in the substrate and/or resin layer(s), as appropriate.

A film according to the invention is of utility in a wide range of applications, including filters for lighting, decorative metallised films, and particularly in electrical applications such as the production of electrical circuit boards, capacitors, magnetic recording media, membrane touch switch (MTS) assemblies and insulating components.

The invention is illustrated by reference to the accompanying drawings in which:

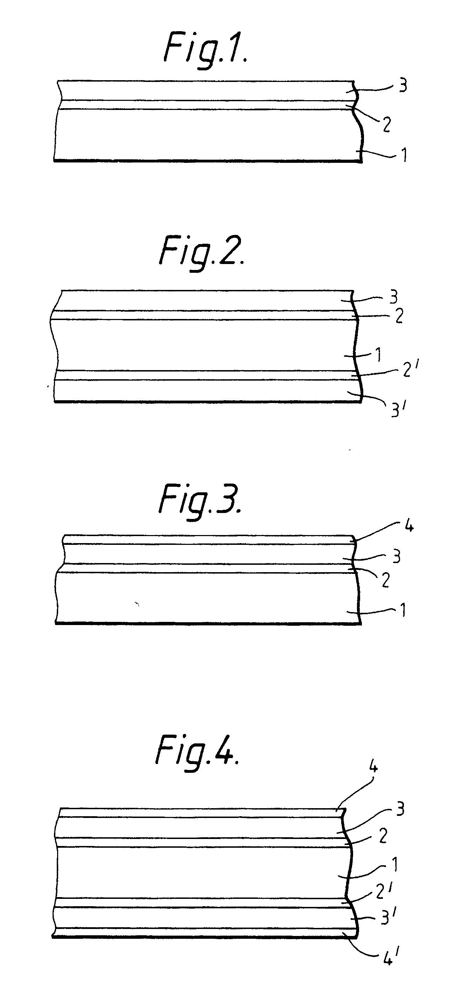

Figure 1 is a schematic elevation (not to scale) of a portion of a flame-retardant film comprising an oriented polymeric substrate 1 on a first surface of which is a receptive layer 2 to which is bonded a flame-retardant layer 3,

Figure 2 is a fragmentary schematic elevation of a similar film in which an additional receptive $2^1$ and associated flame-retardant layer $3^1$ are provided at the second surface of substrate 1.

Figure 3 is a fragmentary schematic elevation of a film similar to that of Figure 1 with the addition of an adhesion-promoting harrier layer 4 on the surface of layer 3 remote from substrate 1, and

Figure 4 is a fragmentary schematic elevation of a film similar to that of Figure 3 with the addition, on the second surface of substrate 1, of, in sequence, a receptive layer $2^1$, a flame-retardant layer $3^1$ and an adhesion-promoting barrier layer $4^1$.

The invention is further illustrated by reference to the following Examples.

Example 1

Each surface of a biaxially oriented, uncoated, polyethylene terephthalate film base sheet of about 125 μm thickness and containing about 0.2 wt% of china clay filler of average particle size less than 2 μm, was treated with a solution in acetone of p-chloro-m-cresol (2.5% weight/vol) and VINYLITE VAGH (0.5% weight/vol). VINYLITE VAGH, supplied by Union Carbide, is a copolymer of vinylchloride (90% wt%) and vinyl acetate (4 wt%) with 2.3 wt% hydroxyl content and of average molecular weight 23,000.

The treated sheet was then dried for 2 minutes in a hot air oven maintained at a temperature of 70°C to leave a residual receptive layer of approximately 0.2 μm thickness on each surface.

Each receptive layer surface was then coated with the following solution:-

| QUATREX 6410 | 9 g |
| Diacetone Alcohol | 3 ml |
| Acetone | 100 ml |

The applied coating was then dried in an air oven at a temperature of 80°C for three minutes to yield a flame-retardant layer of approximately 0.8 μm thickness on each receptive surface.

QUATREX 6410 - supplied by Dow Chemical Co, is a solid brominated epoxy resin: a glycidyl ether of brominated bisphenol A with the following characteristics:

5

| Epoxide equivalent weight | 450 g eq |
|---|---|
| Softening point | 80°C |
| Bromine content (by weight) | 50% |

Each flame-retardant layer was then coated with a solution of the following composition:

| SYTON W15 | 0.15 ml |
|---|---|
| CYASTAT | 0.005 ml |
| Acetone | 35.5 ml |
| Methanol | 64.5 ml |

The applied coating was dried in an air oven at a temperature of 80°C for one minute to yield a non continuous slip coat consisting of silica aggregates.

SYTON W15 - Supplied by Monsanto, is an aqueous colloidal silica dispersion consisting of 15% silica of nominal particle size 125 nm. CYASTAT - Supplied by American Cyanamid Co, is a cationic surfactant wetting agent.

The properties of the product, and of those produced in subsequent Examples, are summarised in the accompanying Table 1.

Example 2

The procedure of Example 1 was repeated, with identical substrate, receptive and slip layers, but the flame-retardant layer was derived from a coating composition comprising:

| QUATREX 6410 | 18 g |
|---|---|
| Diacetone Alcohol | 3 ml |
| Acetone | 100 ml |

The resultant coating was dried as in Example 1 to yield a flame-retardant layer of about 1.5 $\mu$m thickness.

Example 3

A film was made by the procedure of Example 1, with identical substrate and receptive layers, but the slip layer was omitted, and the flame-retardant layer was derived from a solution of the following composition:

| MICROPRO 600 | 0.05 g |
|---|---|
| Diacetone Alcohol | 3 ml |
| GENKLENE | 44 ml |
| Acetone | 49 ml |

The applied coating was dried as in Example 1 to yield a flame retardant layer approximately 0.8 $\mu$m thick.

MICROPRO 600 - supplied by Micro Powders Incorporated is a micronised modified polypropylene wax of nominal particle size 2.5 $\mu$m.

GENKLENE - supplied by ICI Chemicals & Polymers Limited is 1,1,1-Trichloroethane.

Example 4

The procedure of Example 3 was repeated, save that the flame-retardant layer was of 1.4 μm thickness and was derived from the following composition:

| | |
|---|---|
| QUATREX 6410 | 9.0 g |
| EPIKOTE 1009 | 4.5 g |
| MICROPRO 600 | 0.05 g |
| Diacetone Alcohol | 2.7 ml |
| Methyl ethyl ketone | 87.3 ml |

EPIKOTE 1009 - supplied by Shell Chemicals, is a solid bisphenol A - epichlorohydrin type epoxide resin:
Epoxy molar mass 2400 to 4000 g
Softening range 140 to 155°C
Molecular weight approximately 3,750.

Example 5

The procedure of Example 3 was repeated, save that the flame-retardant layer was of 1.0 μm thickness and was derived from the following composition:

| | |
|---|---|
| QUATREX 6410 | 9.5 g |
| Eastman Cellulose Acetate E-398-3 | 2.5 g |
| EPIKOTE 1009 | 1.2 g |
| MICROPRO 600 | 0.05 g |
| Diacetone Alcohol | 3 ml |
| Methyl ethyl ketone | 93 ml |

Eastman Cellulose Acetate E-398-3 - supplied by Eastman Kodak, is a grade of cellulose acetate with an acetyl content of approximately 39.8%.

Example 6

The procedure of Example 4 was repeated with the addition on each flame-retardant layer of an adhesion-promoting barrier layer of about 3.0 μm thickness, after air-drying at a temperature of 100°C for 2 minutes, derived from the following coating composition:

| | |
|---|---|
| Eastman Cellulose Acetate E-398-3 | 1.64 g |
| EPIKOTE 1009 | 1.8 g |
| MICROPRO 600 | 0.05 g |
| Diacetone Alcohol | 2.7 ml |
| Methanol | 11.8 ml |
| Methyl ethyl ketone | 83.2 ml |

Example 7

The procedure of Example 3 was repeated, save that the substrate was an unfilled biaxially oriented polyethylene terephthalate film of 125 μm thickness.

In evaluating the products of the Examples, the following Test Procedures were adopted:

TEST PROCEDURES

1 Stress crazing

A 2 cm wide strip of film is folded through 180° to form a sharp crease. The sample is opened flat and degree of crazing/damage to the coating is assessed a) visually and b) by adhering and sharply removing adhesive tape (Tesa 4104) from the test area. Samples are graded in accordance with the following scheme:

Grade

1 - No visible effect
2 - Slight crazing (micro cracks confined 1 mm either side of crease line). Coating remains intact after tape test.
3 - Moderate crazing micro cracks extend 1-2 mm from crease line. Coating remains intact after tape test.
4 - Coating damaged, cracks as grades 2 or 3 coating removed partially or totally after tape test.
5 - Severe damage, coating flakes off partially or totally prior to tape test.

2 Minimum blocking temperature

Film samples (75 x 100 mm) are placed face to face and supported on a preheated glass plate. A second pre-heated glass plate (6.35 mm thick) is placed on top of the samples and the stack is maintained at the test temperature for a period of 10 minutes (Test load = 1.7 g/cm$^2$). After 15 minutes the samples are removed from the oven and allowed to cool. The degree of blocking occurring between the sample surfaces is assessed, by attempting to separate the samples. The minimum blocking temperature is the minimum test temperature at which physical damage is evident on the sample surfaces after separation.

3 Adhesion to support

Adhesion is assessed by, I) scoring through the coatings a cross hatch pattern consisting of 9 squares within a 2 x 2 area using the edge of a scalpel, II) adhering firmly Tesa tape 4104 over the test area, III) sharply removing the tape, IV) assessing the amount of coating removed by the number of non-intact squares, and V) repeating stages II)-IV) a further seven times. Adhesion is expressed as the number of squares removed over the number of tape pulls eg 0/8 = no coating removed after 8 tape pulls.

4 Surface Friction

Coefficients of static and kinetic friction are determined by a moving sledge method on samples of film which have been allowed to equilibrate for one hour at a temperature of 20°C and 60% Relative Humidity.

5 Adhesion Promotion

Adhesion promotion characteristics of the coated product are assessed with a representative range of conductive inks and dielectric varnishes employed in the manufacture of MTS assemblies. Proprietary inks/dielectrics are applied and cured as recommended by the manufacturer. Adhesion to the coated support is assessed by the cross hatch tape test described in 3) above.

6 Optical Properties

Haze and Total light Transmission (TLT) - Gardner/Neotec Instruments - model XL211

60° Gloss - Diffusion Systems - model DS29

TABLE 1

| Example | No of Coats (each side) | Coating assembly | PROPERTY | | | | | | | | | |
|---|---|---|---|---|---|---|---|---|---|---|---|---|
| | | | Stress crazing | blocking at elevated temp | handling/friction | abrasion resistance | haze | TLT | 60° gloss | adhesion to Support | adhesion Promotion | UL-94 VTM-2 |
| 1 and 2 | 3 | a)prime-VAGH/pcmc<br>b)FR-QUATREX<br>c)slip-SYTON CYASTAT | poor | poor | poor | poor | low | high | high | good | good | yes |
| 3 | 2 | a)prime-VAGH/pcmc<br>b)FR-QUATREX/MICROPRO | poor | poor | mod | poor | low | high | high | good | good | yes |
| 4 | 2 | a)prime-VAGH/pcms<br>b)FR-QUATREX/EPIKOTE MICROPRO | mod | poor | mod | mod | low | high | high | good | good | yes |
| 5 | 2 | a)Prime-VAGH/pcmc<br>b)FR-QUATREX/E398-3/EPIKOTE/MICROPRO | mod | mod | mod | mod | high | high | mod | good | good | yes |
| 6 | 3 | a)Prime-VAGH/pcmc<br>b)FR-QUATREX/EPIKOTE/MICROPRO<br>c)barrier-E398-3/EPIKOTE/MICROPRO | mod | good | good | good | mod | high | mod | good | good | yes |
| 7 | 2 | a)Prime-VAGH/pcmc<br>b)FR-QUATREX/MICROPRO | poor | poor | mod | poor | low | high | high | good | good | yes |

EP 0 417 946 A2

From the test data in Table 1 it is evident that although the products of Examples 1 to 7 each satisfy the flame-retardancy criteria specified in UL-94 VTM-2, several exhibit characteristics which might impose varying degrees of constraint on the processability of the film by converters and/or restrict the range of end applications. For example, poor blocking resistance at elevated temperatures could impose an uneconomic constraint on the curing regime employed by converters when printing conductive circuitry layer inks. Inadequate adhesion promotion would limit the range of conductive inks and dielectrics compatible with the film and reduce the number of end applications. High gloss and/or haze might introduce problems with registration during printing operations.

The film of Example 6, therefore represents a preferred embodiment of the invention. Characteristics of the film of Example 6, measure in accordance with the aforementioned Test Procedures 1 to 6, are detailed hereinafter:

| Properties of the film of Example 6 | | |
|---|---|---|
| 1 Stress crazing - grade 2 | | |
| 2 Minimum blocking temp - 120° C | | |
| 3 Adhesion to support 0/8 | | |
| 4 Surface friction coefficient | - static | - 0.46 |
| | - dynamic | - 0.43 |

TABLE 2A

| CONDUCTIVE INK | ADHESION | | |
|---|---|---|---|
| | EXAMPLE 6 | EXAMPLE A (comparative) | EXAMPLE B (comparative) |
| Acheson 477SS (Silver) | 0/8 | 0/8 | 0/8 |
| Acheson 418 (Silver) | 0/8 | 0/8 | 0/8 |
| Johnson Matthey P1856 (Silver) | 0/8 | 0/8 | 0/8 |
| Olin Hunt 725A (Silver) | 0/8 | 0/8 | 0/8 |
| Coates 26-8204 (Silver) | 0/8 | 0/8 | 0/8 |
| Acheson 423 (graphite) | 1/8 | 1/8 | 1/8 |
| Johnson Matthey P1168 (graphite) | 0/8 | 0/8 | 0/8 |
| Olin Hunt 440A (graphite) | 0/8 | 0/8 | 0/8 |
| Coates 26-8203(graphite) | 0/8 | 0/8 | 0/8 |
| Ink application thickness 24 μm (wet) | | | |
| Curing conditions - 10 minutes at 120° C | | | |
| Adhesion - assessed by test method No 5 | | | |

TABLE 2B

| DIELECTRIC | SINGLE OR DOUBLE APPLICATION | ADHESION | | |
|---|---|---|---|---|
| | | EXAMPLE 6 | EXAMPLE A (comparative) | EXAMPLE B (comparative) |
| Acheson 451SS | single | 1/8 | 9/1 | 1/8 |
| Acheson 451SS | double | 1/8 | 9/2 | 1/8 |
| Coates 30-302 | single | 0/8 | 9/1 | 0/8 |
| Coates 30-302 | double | 0/8 | 9/1 | 0/8 |
| Olin Hunt 26NCP68 | single | 0/8 | 9/1 | 0/8 |
| Olin Hunt 26NCP68 | double | 0/8 | 9/1 | 0/8 |
| Dielectric application thickness - 24 $\mu$m (wet) each application. UV-cured dielectrics cured by single exposure to one 200 W/25 mm medium pressure mercury arc lamp in a Primarc Minicure (Trade Mark) unit operating at 4.5 m/min. | | | | |

6 Optical Properties

Haze - 70%
TLT - 84.0%
60° gloss - 54

To facilitate comparison, the characteristics of several commercially available grades of heat stabilised MELINEX brand polyethylene terephthalate film of 125 $\mu$m thickness supplied by ICI Films, and currently used in membrane touch switch applications are appended in Table 3.

The comparative films are identified by the letters A to F, as follows:

A) MELINEX ST 507 (S grade)
B) MELINEX ST 542 (in-line acrylic pretreated)
C) MELINEX ST 508 (off-line coated)
D) MELINEX ST 520 (standard)
E) MELINEX ST 505 (in-line acrylic pretreated)
F) MELINEX ST 525 (off-line coated)

In addition, comparative Example 0 records a procedure in which the receptive and flame-retardant compositions of Example 1 were combined into a single coating composition (in the absence of any additional slip or modifying layer), and applied to a substrate identical to that of Example 1.

TABLE 3

| Comparative Example | No of Coats (each side) | Coating Assembly | PROPERTY | | | | | | | | | |
|---|---|---|---|---|---|---|---|---|---|---|---|---|
| | | | Stress crazing | blocking at elevated temp | handling/friction | abrasion resistance | haze | TLT | 60° gloss | adhesion to support | adhesion Promotion | UL-94 VTM-2 |
| A | 0 | | good | good | good | good | low | high | high | - | poor | yes |
| B | 1 | in-line acrylic pretreat | good | good | mod | mod | low | high | high | good | good | no |
| C | 2 | a)prime-VAGH/ b)slip-SYTON/CYASTAT | good | poor | good | mod | low | high | high | good | good | no |
| D | 0 | | good | good | mod | good | vlow | high | high | - | poor | no |
| E | 1 | in-line acrylic | good | mod | mod | mod | vlow | high | high | good | good | no |
| F | 2 | a)prime-VAGH/pcmc b)slip-SYTON/CYASTAT | good | poor | mod | mod | low | high | high | good | good | no |
| O | 1 | QUATREX + pcmc | poor | poor | poor | poor | low | high | high | poor | poor | ? |

Example 8

Each surface of a biaxially oriented, uncoated, polyethylene naphthalate film base sheet of about 55 $\mu$m thickness and containing about 0.1 wt% of china clay filler was coated with a receptive layer as described in Example 1.

Each receptive layer surface was coated with the following solution:-

| QUATREX 6410 | 13.5 g |
| EPIKOTE 1009 | 6.8 g |
| MICROPRO 600 | 0.05 g |
| Diacetone alcohol | 2.6 ml |
| Methylethyl ketone | 81 ml |

The applied coating was dried as in Example 1. The adhesion to support of the flame-retardant layer was moderate.

The U2-94 flame-retardancy rating was improved from VTM-2 (for uncoated polyethylene naphthalate film) to VTM-0.

Example 9

A polyethylene terephthalate film was melt extruded, cast onto a cooled rotating drum and stretched in the direction of extrusion to approximately 3 times its original dimensions. The cooled stretched film was then coated with an aqueous receptive layer coating composition containing the following ingredients:

| Acrylic resin (46% w/w aqueous latex of methyl methacrylate/ethyl acrylate/methacrylamide : 46/46/8 mole %, with 25% by weight methoxylated melamine-formaldehyde) | 65.2 ml |
| DL685 (46% w/w aqueous latex of butadiene/styrene : 1.0/1.4 mole, supplied by Dow) | 65.2 ml |
| Ammonium nitrate (10% w/w aqueous solution) | 10 ml |
| Synperonic NP 10 (10% w/v aqueous solution of an alkyl nonylphenol ethoxylated surfactant, supplied by ICI) | 100 ml |
| Dimeralised water to | 2000 ml |

The polyethylene terephthalate film was coated on both sides.

The coated film was passed into a stenter oven, where the film was dried and stretched in the sideways direction to approximately 3 times its original dimensions. The biaxially stretched coated film was heat set at a temperature of about 200°C by conventional means. Final film thickness was 125 $\mu$m, with a dry receptive layer coat weight of approximately 1 mgdm$^{-2}$ on each side of the substrate.

Each receptive layer surface was then coated with the flame-retardant coating composition described in Example 8.

The adhesion to support of the flame-retardant layer was good. The UL-94 flame-retardancy rating was improved from unclassified (for polyethylene terephthalate coated with the receptive layer) to VTM-2.

Example 10

A film was made by the procedure of Example 1, with identical substrate and receptive layers, but the slip layer was omitted, and the flame retardant layer was derived from a solution of the following composition:

| BREN S | 14.4 g |
| EPIKOTE 1009 | 7.2 g |
| MICROPRO 600 | 0.07 g |
| Diacetone alcohol | 3.9 ml |
| Methyl ethyl ketone | 82 ml |
| The applied coating was dried as in Example 1. | |

BREN S - supplied by Nippon Kayaku Co, is a polyglycidyl ether of brominated phenol - formaldehyde novolac with the following characteristics:

| Epoxide equivalent weight | 285 ± 5 g eq |
| Softening point | 80 - 90°C |
| Bromine content (by weight) | 35.5 - 36.5% |

The adhesion to support of the flame-retardant layer was good. The UL-94 flame-retardancy rating was VTM-2.

Example 11

The procedure of Example 10 was repeated with the addition on each flame-retardant layer of an adhesion-promoting barrier layer as described in Example 6.

The adhesion to support was good and the UL-94 flame-retardancy rating was VTM-2.

Example 12

A film was made by the procedure of Example 11, with identical substrate, receptive and barrier layers, but the flame-retardant layer was derived from a solution of the following composition:

| MAKHTESHIM F-2001P | 14.4 g |
| MICROPRO 600 | 0.07 g |
| Diacetone alcohol | 3.9 ml |
| Methyl ethyl ketone | 89 ml . |
| The applied coating was dried as in Example 11. | |

MAKHTESHIM F-2001P - supplied by Makhteshim Chemical Works Ltd, Israel, is a glycidyl ether of brominated bisphenol A with the following characteristics:

| Epoxide equivalent weight | 545 ± 35 g eq |
| Softening point | 60 - 70°C |
| Bromine content (by weight) | 48 - 50% |

The adhesion to support was good and the UL-94 flame-retardancy rating was VTM-2.

Example 13

A film was made by the procedure of Example 1, with identical substrate and receptive layers, but the slip layer was omitted, and the flame-retardant layer was derived from a solution of the following composition:

| MAKHTESHIM F-2300 | 11.1 g |
|---|---|
| Methylene chloride | 90 ml |
| Methanol | 10 ml |
| Benzyl alcohol | 9 ml |
| The applied coating was dried as in Example 1. | |

MAKHTESHIM F-2300 - supplied by Makhteshim Chemical Works Ltd, is a modified glycidyl ether of brominated bisphenol A with the following characteristics:

| Epoxide equivalent weight | 1900 ± 200 g eq |
|---|---|
| Softening point | 120 - 140 °C |
| Bromine content (by weight) | 50% |

The adhesion to support of the flame-retardant layer was satisfactory. The UL-94 flame-retardancy rating was VTM-2.

Example 14

A film was made by the procedure of Example 1, with identical substrate and receptive layers, but the slip layer was omitted, and the flame-retardant layer was derived from a solution of the following composition:

| MAKHTESHIM F-2400 | 11.1 g |
|---|---|
| Methylene chloride | 90 ml |
| Methanol | 10 ml |
| Benzyl alcohol | 9 ml |
| The applied coating was dried as in Example 1. | |

MAKHTESHIM F-2400 - supplied by Makhteshim Chemical Works Ltd, is a higher molecular weight variant of Makhteshim F-2300. The nominal molecular weight of F-2400 is 40,000 and it has the following characteristics:

| Epoxide equivalent weight | - |
|---|---|
| Softening point | 140 - 160 °C |
| Bromine content (by weight) | 51 - 53.5% |

The adhesion to support of the flame-retardant layer was good. The UL-94 flame-retardancy rating was VTM-2.

## Claims

1. A flame-retardant film comprising a polymeric substrate having a flame-retardant layer on a surface thereof characterised in that at least one surface of the substrate comprises a receptive layer and, on the at least one receptive layer, a retardant layer comprising a flame-retardant agent consisting essentially of a halogenated epoxy resin.

2. A film according to claim 1 wherein the flame-retardant agent comprises a polymeric glycidyl ether of brominated bisphenol b.

3. A film according to either of claims 1 and 2 wherein the retardant layer comprises a polymeric wax.

4. A film according to any one of the preceding claims wherein the retardant layer comprises a compatible flex-promoting resin.

5. A film according to any one of the preceding claims wherein the receptive layer is formed by treatment with a medium comprising a halogenated phenol.

6. A film according to any one of the preceding claims additionally comprising a modifier layer on a surface of the flame-retardant layer remote from the substrate.

7. A film according to claim 6 wherein the modifier layer comprises a slip coat.

8. A film according to claim 6 wherein the modifier layer comprises an adhesion-promoting barrier layer.

9. A film according to claim 8 wherein the modifier layer comprises a blend of a cellulosic resin and an epoxy resin.

10. A method of producing a flame-retardant film characterised by forming a polymeric substrate, treating at least one surface of the substrate to form a receptive layer thereon, and forming on the receptive layer a retardant layer comprising a flame-retardant agent consisting essentially of a halogenated epoxy resin.

## Fig.1.

## Fig.2.

## Fig.3.

## Fig.4.